# EUROPEAN PATENT SPECIFICATION

(11) **EP 1 388 938 B1**
(45) Date of publication and mention of the grant of the patent: **26.12.2007**
(21) Application number: 03016929.6
(22) Date of filing: 24.07.2003
(51) Int. Cl.: H03H 3/02, H03H 9/205, H03H 9/54

(54) **Manufacturing film bulk acoustic resonator filters**
Herstellen des Dünnfilmresonatorfilters
Production des filtres à résonateur en couche mince et à ondes acoustiques de volume

(30) Priority: 08.08.2002 US 215407
(43) Date of publication of application: 11.02.2004
(73) Proprietor: INTEL CORPORATION, Santa Clara, CA 95054-1549 (US)
(72) Inventor: Wang, Li-Peng, San Jose, CA 95129 (US); Bar-Sadeh, Eyal, Jerusalem, Israel 96269 (IL); Rao, Valluri, Saratoga, CA 95070 (US); Heck, John, Palo Alto CA 94306 (US); Ma, Qing, San Jose, CA 95129 (US); Tran, Quan, Fremont, CA 94539 (US); Talalyevsky, Alexander, Jerusalem, Israel 93387 (IL); Ginsburg, Eyal, Tel-Aviv (IL)
(74) Representative: Jacoby, Georg

(56) References cited:
- EP-A- 1 017 170
- DE-A- 10 119 442
- US-A- 5 192 925
- US-A- 5 231 327
- P KAZINCZI, P TURMEZEI, J R MOLLINGER, A BOUSSCHE: "Design of Low-Cost Resonant Mode Sensors" PROCEEDING OF THE SPIE - THE INTERNATIONAL SOCIETY FOR OPTICAL ENGINEERING, 2001, vol. 4593, 17 December 2001 (2001-12-17), - 19 December 2001 (2001-12-19) pages 54-61, XP0001188961 ADELAIDE, SA, AUSTRALIA
- PATENT ABSTRACTS OF JAPAN vol. 0124, no. 65 (E-690), 7 December 1988 (1988-12-07) -& JP 63 187714 A (TOSHIBA CORP), 3 August 1988 (1988-08-03)

## Description

### Background

This invention relates to film bulk acoustic resonator filters.

A conventional film bulk acoustic resonator filter includes two sets of film bulk acoustic resonators to achieve a desired filter response. All of the series film bulk acoustic resonators have the same frequency and the shunt film bulk acoustic resonators have another frequency. The active device area of each film bulk acoustic resonator is controlled by the overlapping area of top and bottom electrodes, piezoelectric film, and backside cavity.

The backside cavity of a film bulk acoustic resonator is normally etched by crystal orientation-dependent etching, such as potassium hydroxide (KOH) or ethylenediamene pyrocatecol (EDP). As a result, the angle of sidewall sloping is approximately 54.7 degrees on each side. When a filter is made up of a plurality of series and shunt FBARs, each having a backside cavity with sloping sidewalls, the size of the filter may be significant.

US-A-5 231 327 shows the preamble of the independent claims.

The document "Design of Low-Cost Resonant Mode Sensors" by R. Kazinczi et al., proceeding of the spie - THE INTERNATIONAL SOCIETY FOR OPTICAL ENGINNERING, Society for Optical Engineering, 2001, Vol. 4593, pages 54-61 shows a resonance sensor having a vibrating element and a resonate membrane. A local reinforcing bump is attached to the middle section of the membrane so that the middle section behaves as a rigid body and deformation of the membrane is concentrated in the region of the membrane adjacent to the reinforcing bump where sensing elements are positioned.

Thus, there is a need for better ways to make film bulk acoustic resonator filters.

### Brief Description of the Drawings

Figure 1 is top plan view of a film bulk acoustic resonator filter in accordance with one embodiment of the present invention;
Figure 2 is a cross-sectional view taken generally along the line 2-2 at an early stage of manufacturing the embodiment shown in Figure 1 in accordance with one embodiment of the present invention;
Figure 3 shows a subsequent stage of manufacturing in accordance with one embodiment of the present invention;
Figure 4 shows a subsequent stage in accordance with one embodiment of the present invention;
Figure 5 shows a subsequent stage in accordance with one embodiment of the present invention;
Figure 6 shows a subsequent stage in accordance with one embodiment of the present invention;
Figure 7 shows a subsequent stage in accordance with one embodiment of the present invention;
Figure 8 shows a subsequent stage in accordance with one embodiment of the present invention; and
Figure 9 shows a subsequent stage in accordance with one embodiment of the present invention.

### Detailed Description

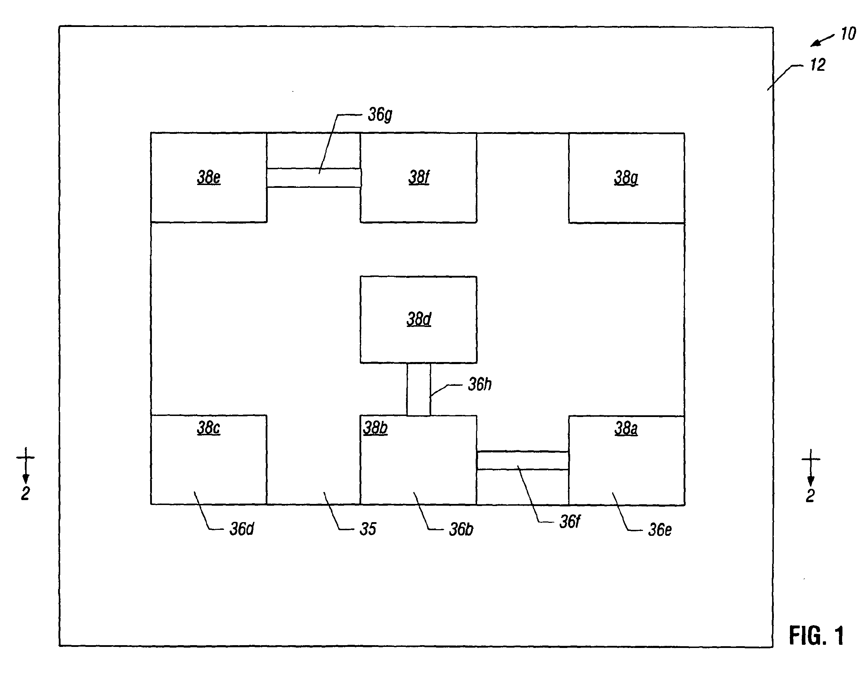

Referring to Figure 1, a film bulk acoustic resonator (FBAR) filter 10 include a plurality of film bulk acoustic resonators 38 having top electrodes 36. The FBARS 38c and 38a are shunt FBARs while the FBAR 38b is a series FBAR coupled to the FBAR 38a via an extension 36f of the upper electrodes 36b and 36e.

The intermediate layer in each FBAR 38 includes a piezoelectric film. In one embodiment, the same layer of piezoelectric film may be positioned underneath each of the upper electrodes 36 of the FBARs 38. Thus, in one embodiment, the material 35 may be a piezoelectric film. In another embodiment, the material 35 may include an interlayer dielectric (ILD) that fills the area between FBARs 38 while the region under each upper electrode 36 is a piezoelectric film.

In one embodiment, the active area of each FBAR 38 is controlled by the extent of overlapping between the upper electrode 36 and the underlying piezoelectric film, as well as the lowermost or bottom electrode. In some embodiments all of the FBARs 38 are effectively coupled through a single membrane, be it a continuous piezoelectric film or a layer that includes regions of piezoelectric film separated by an interlayer dielectric.

Strengthening strips are used to improve the mechanical strength of the overall filter 10. The strengthening strips may be designed in any of a variety of shapes.

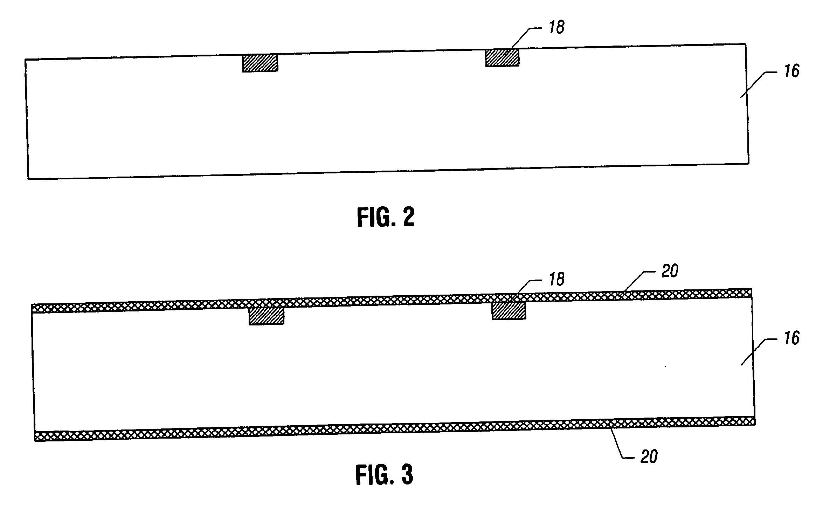

Referring to Figure 2, the initial fabrication begins by forming the ion implanted regions 18. The ion implanted regions 18 become the strengthening strips. The ion implant may be, for example, oxygen or heavy boron, using a heavy boron etch-stop method. Then a rapid thermal anneal may be utilized to activate the doping. Cascade implantation may be used in some embodiments to achieve a uniform profile. In some embodiments the thickness of the implanted and annealed region is about 6 micrometers.

Next, an insulating layer 20 may be deposited on the top and bottom surfaces of the substrate 16. In one embodiment, the layer 20 may be formed of silicon nitride that acts as an etch stop layer and a backside etching mask.

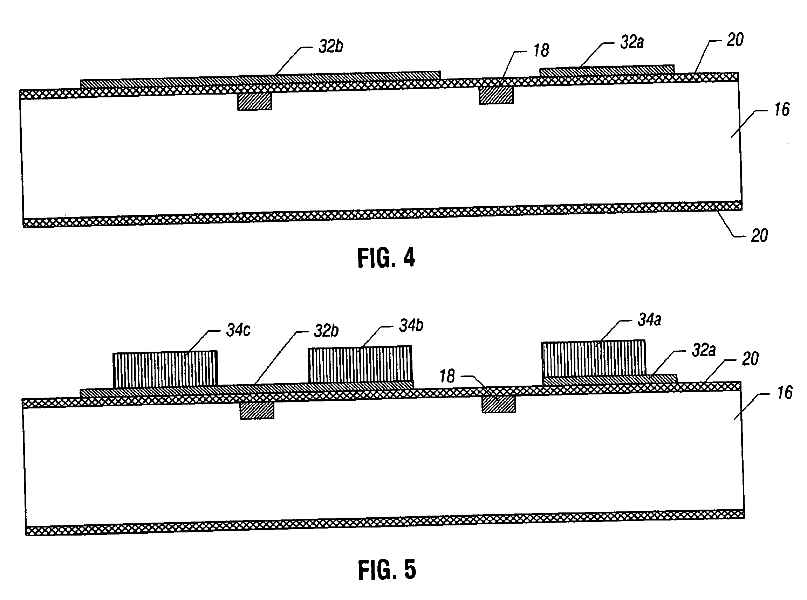

Turning next to Figure 4, the bottom electrodes 32 may be defined by deposition and patterning in one embodiment of the present invention. Next, as shown in Figure 5, the piezoelectric layer 34 may be deposited and patterned over the bottom electrodes 32 in one embodiment of the present invention. In another embodiment, a continuous piezoelectric film may be utilized.

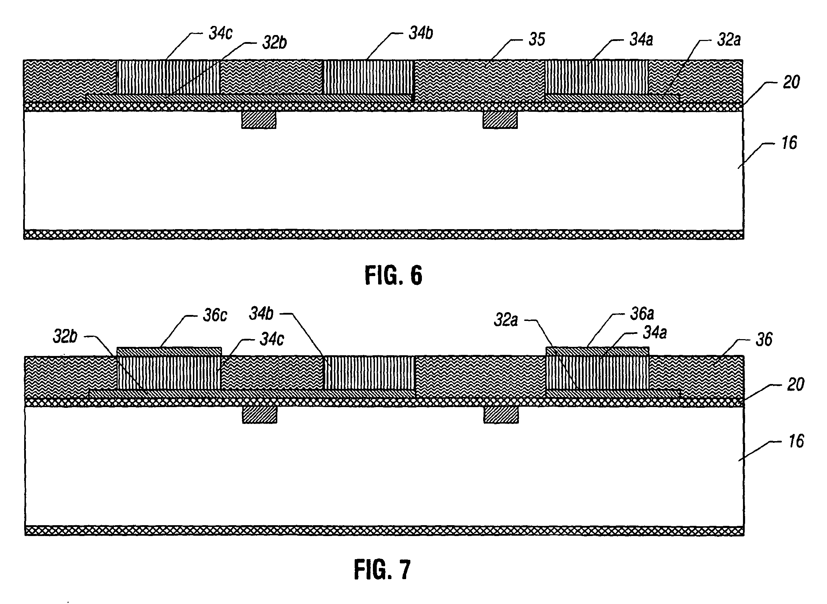

Referring to Figure 6, an interlayer dielectric 35 may be deposited between the piezoelectric layer 34 sections such as the sections 34a and 34b. Chemical mechanical polishing may be used to cause the upper surface of the interlayer dielectric 35 to be co-planar with the upper surface of each piezoelectric layer 34 section.

Turning next to Figure 7, the upper electrodes 36a and 36c for the shunt FBARs 38a and 38c are deposited. Thus, referring to Figure 1, each of the electrodes 38 is a generally rectangular section in one embodiment. Any necessary vias may be etched at this time.

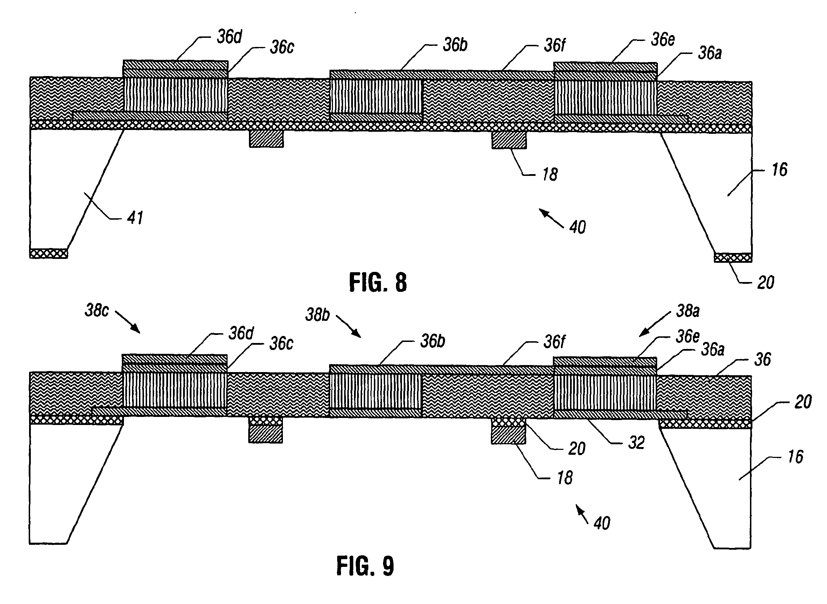

Referring to Figure 8, the backside etch may be utilized to form the backside cavity 40 with sloping sidewalls 41. The initial etch may not extend through the lowermost insulator film 20 in one embodiment. Thereafter, a bulk silicon etch may be utilized to form the cavity 40 through the substrate 16. The implanted regions 18 remain after this etching because the etchant is selective of bulk silicon compared to doped silicon. Suitable etchants include KOH and EDP.

By having all of the FBARs 38 on the same membrane the overall size of the filter 10 may be reduced. For example, only one backside cavity 40 may be used for a number of FBARs 38, resulting in a more compact layout made up of FBARs that may be closely situated to one another. In some embodiments, portions of the interlayer dielectric 35 near the outer edges of the filter 10 may be removed to achieve the structure shown in Figure 1.

The electrodes 36b, 36f, 36d, and 36e may be deposited. The electrode 36b acts as the upper electrode of the series FBAR 38b in this example. The electrodes 36d and 36e may be added to differentiate the frequency of the shunt FBARs 38a and 38c from the frequency of the series FBAR 38b. The electrode 36f acts to couple the FBARs 38b and 38a through their upper electrodes. However, the electrodes 36d, 36b, 36f, and 36e may be added in the same step in one embodiment.

As shown in Figure 9, the layer 20 may be etched to complete the formation of the strengthening strips in the backside cavity 40. In some embodiments the strengthening strips may be arranged in a # shape with two parallel strengthening strips arranged generally transversely to two other parallel strengthening strips. However, a variety of configurations of strengthening strips may be used in various embodiments.

The filter 10, shown in Figure 1, has all series and shunt FBARs in one cavity 40 and the active area of each FBAR is controlled by the overlapping area. The strips of implanted regions 18 act as strengthening strips to improve the mechanical strength of the entire structure.

In accordance with other embodiments of the present invention, the strengthening strips may be formed by etching trenches in the substrate 16 and filling those trenches with an insulator such as low pressure chemical vapor deposited silicon nitride. The trenches may then be filled to form the strengthening strips.

By making a more compact design, with shorter traces such as electrodes 36f, 36h, and 36g, insertion loss and pass-to-stop band roll-off may be improved in some embodiments.

While the present invention has been described with respect to a limited number of embodiments, those skilled in the art will appreciate numerous modifications and variations therefrom. It is intended that the appended claims cover all such modifications and variations as fall within the true spirit and scope of this present invention.

## Claims

1. A method for forming a film bulk acoustic resonator filter comprising:
forming a plurality of series connected film bulk acoustic resonators (38b) on the same substrate (16) electrically coupled by at least one shunt film bulk acoustic resonator (38a; c),
providing a backside cavity (40) on the substrate;
forming at least two resonators (38a-g) over the same backside cavity (40),
**characterized by** further comprising:
forming a strengthening strip (18) extending across said backside cavity (40) to strengthen the membrane of said backside cavity (40).

2. The method of claim 1 including forming an upper electrode (36) from a single conductive layer, said upper electrode (36) being positioned over each film bulk acoustic resonator.

3. The method of claim 1 or 2 including forming at least two parallel strengthening strips (18).

4. The method of any one of claims 1 to 3 including forming a strengthening strip (18) by implanting a region across said substrate (16).

5. The method of claim 4 including implanting the region using a species selected from the group consisting of boron and oxygen.

6. The method of any one of the preceding claims including forming film bulk acoustic resonators (38a-g) by using ah etchant to etch away the backside of said substrate (16) and to form a backside cavity (40).

7. The method of claim 6 wherein the etchant is selective such that the strengthening strip (18) formed in said substrate (16) remains after the etching step.

8. The method of any one of the preceding claims including forming a piezoelectric layer (34) for a plurality of film bulk acoustic resonators (38a-g) on the same substrate (16) using a single film of piezoelectric material.

9. The method of claim 8 including patterning said piezoelectric film (34), removing portions of the piezoelectric film (34), and replacing the removed portions with a dielectric material (35).

10. An integrated circuit comprising:
a substrate (16) ;
a film bulk acoustic resonator filter formed on said substrate (16) and including a plurality of series connected film bulk acoustic resonators (38b) electrically coupled by a shunt film bulk acoustic resonator (38a; c);
a backside cavity on said substrate (16), wherein at least two resonators (38a-g) are formed over the same backside cavity (40),
**characterized by**
a strengthening strip (18) extending across said backside cavity (40) to strengthen the membrane of the backside cavity (40).

11. The circuit of claim 10 including a single backside cavity (40) under said resonators (38a-g).

12. The circuit of claim 10 or 11 including a plurality of strengthening strips (18) extending across said cavity (40).

13. The circuit of any one of claims 10 to 12, wherein said strengthening strips (18) are formed of ion implanted substrate material.

14. The circuit of any one of claims 10 to 13 including a pair of parallel strengthening strips (18).

15. The circuit of any one of claims 10 to 14, wherein each of said resonators (38a-g) includes an upper electrode (36), the upper electrodes (36a-f) of said resonators (38a-g) being co-planar.

## Patentansprüche

1. Verfahren zum Ausbilden eines Filmvolumenakustikresonatorfilters, umfassend:
Ausbilden einer Vielzahl von in Reihe geschalteten Filmvolumenakustikresonatoren (38b) auf dem gleichen Substrat (16), die mit wenigstens einem Nebenschluß-Filmvolumenakustikresonator (38a, c) elektrisch gekoppelt sind,
Bereitstellen einer rückseitigen Kavität (40) auf dem Substrat;
Ausbilden wenigstens zweier Resonatoren (38a-g) über der gleichen rückseitigen Kavität (40),
**dadurch gekennzeichnet, daß** es ferner umfaßt:
Ausbilden eines Verstärkungsstreifens (18), der sich über der rückseitigen Kavität (40) erstreckt, um die Membran der rückseitigen Kavität (40) zu verstärken.

2. Verfahren nach Anspruch 1, das das Ausbilden einer oberen Elektrode (36) aus einer einzelnen leitenden Schicht umfaßt, wobei die obere Elektrode (36) über jedem Filmvolumenakustikresonator positioniert ist.

3. Verfahren nach Anspruch 1 oder 2, das das Ausbilden wenigstens zweier paralleler Verstärkungsstreifen (18) umfaßt.

4. Verfahren nach einem der Ansprüche 1 bis 3, das das Ausbilden eines Verstärkungsstreifens (18) durch Implementieren eines Bereichs über dem Substrat (16) umfaßt.

5. Verfahren nach Anspruch 4, das das Implantieren des Bereiches unter Verwendung einer Spezies umfaßt, die aus der Gruppe ausgewählt ist, die aus Bor und Sauerstoff besteht.

6. Verfahren nach einem der vorhergehenden Ansprüche, das das Ausbilden von Filmvolumenakustikresonatoren (38) unter Anwendung eines Ätzmittels umfaßt, um die Rückseite des Substrates (16) wegzuätzen und eine rückseitige Kavität (40) auszubilden.

7. Verfahren nach Anspruch 6, bei dem das Ätzmittel so selektiv ist, daß der auf dem Substrat (16) ausgebildete Verstärkungsstreifen (18) nach dem Ätzschritt übrig bleibt.

8. Verfahren nach einem der vorhergehenden Ansprüche, das das Ausbilden einer piezoelektrischen Schicht (34) für eine Vielzahl von Filmvolumenakustikresonatoren (38a-g) auf dem gleichen Substrat (16) unter Verwendung eines einzelnen Films aus einem piezoelektrischen Material umfaßt.

9. Verfahren nach Anspruch 8, das das Mustern des piezoelektrischen Films (34), das Entfernen von Abschnitten des piezoelektrischen Films (34), und das Ersetzen der entfernten Abschnitte durch ein dielektrisches Material (35) umfaßt.

10. Integrierte Schaltung, mit:
einem Substrat (16);
einem Filmvolumenakustikresonatorfilter, der auf dem Substrat (16) ausgebildet ist und eine Vielzahl an in Reihe geschalteten Filmvolumenakustikresonatoren (38b) umfaßt, die elektrisch mit einem Nebenschluß-Filmvolumenakustikresonator (38a; c) gekoppelt sind;
einer rückseitigen Kavität auf dem Substrat (16), wobei wenigstens zwei Resonatoren (38a-g) über der gleichen rückseitigen Kavität (40) angeordnet sind,
**gekennzeichnet durch**
einen Verstärkungsstreifen (18), der sich über der rückseitigen Kavität (40) erstreckt, um die Membran der rückseitigen Kavität (40) zu verstärken.

11. Schaltung nach Anspruch 10, die eine einzelne rückseitige Kavität (40) unter den Resonatoren (38a-g) umfaßt.

12. Schaltung nach Anspruch 10 oder 11, die mehrere Verstärkungsstreifen (18) umfaßt, die sich über die Kavität (40) erstrecken.

13. Schaltung nach einem der Ansprüche 10 bis 12, bei der die Verstärkungsstreifen (18) aus einem ionenimplantierten Substratmaterial gebildet sind.

14. Schaltung nach einem der Ansprüche 10 bis 13, die ein Paar paralleler Verstärkungsstreifen (18) umfaßt.

15. Schaltung nach einem der Ansprüche 10 bis 14, bei der jeder der Resonatoren (38a-g) eine obere Elektrode (36) umfaßt, wobei die oberen Elektroden (36a-f) der Resonatoren (38a-g) plan-parallel sind.

## Revendications

1. Procédé de fabrication d'un filtre à résonateur en couche mince et à ondes acoustiques de volume, comprenant les étapes consistant à :
■ former une pluralité de résonateurs en couche mince et à ondes acoustiques de volume connectés en série (38b) sur le même substrat (16) couplés électriquement par au moins un résonateur en couche mince et à ondes acoustiques de volume shunté (38a ; c),
■ réaliser une cavité arrière (40) sur le substrat ;
■ former au moins deux résonateurs (38a à g) en dessus de la même cavité arrière (40),
**caractérisé en ce qu'**il comprend par ailleurs l'étape consistant à :
■ former une bande de renfort (18) qui s'étend sur ladite cavité arrière (40) dans le but de renforcer la membrane de ladite cavité arrière (40).

2. Procédé selon la revendication 1 comprenant l'étape consistant à former une électrode supérieure (36) à partir d'une couche conductrice unique, ladite électrode supérieure (36) étant positionnée en dessus de chaque résonateur en couche mince et à ondes acoustiques de volume.

3. Procédé selon la revendication 1 ou 2 comprenant l'étape consistant à former au moins deux bandes de renfort parallèles (18).

4. Procédé selon l'une quelconque des revendications 1 à 3 comprenant l'étape consistant à former une bande de renfort (18) en implantant une région sur toute la surface dudit substrat(16).

5. Procédé selon la revendication 4 comprenant l'étape consistant à implanter la région en utilisant une espèce sélectionnée dans le groupe composé de bore et d'oxygène.

6. Procédé selon l'une quelconque des revendications précédentes comprenant l'étape consistant à former des résonateurs en couche mince et à ondes acoustiques de volume (38a à g) en utilisant un agent de gravure pour décaper l'arrière dudit substrat (16) et pour former une cavité arrière (40).

7. Procédé selon la revendication 6, dans lequel l'agent de gravure est sélectif, de telle sorte que la bande de renfort (18) formée dans ledit substrat (16) reste présente après l'étape de gravure.

8. Procédé selon l'une quelconque des revendications précédentes comprenant l'étape consistant à former une couche piézo-électrique (34) pour une pluralité de résonateurs en couche mince et à ondes acoustiques de volume (38a à g) sur le même substrat (16) en utilisant une couche unique de matériau piézo-électrique.

9. Procédé selon la revendication 8 comprenant l'étape consistant à façonner ladite couche de matériau piézo-électrique (34), à éliminer des portions de la couche de matériau piézo-électrique (34), et à remplacer les portions éliminées par un matériau diélectrique (35).

10. Circuit intégré, comprenant:
■ un substrat (16) ;
■ un filtre à résonateur en couche mince et à ondes acoustiques de volume formé sur ledit substrat (16) et comprenant une pluralité de résonateurs en couche mince et à ondes acoustiques de volume connectés en série (38b) couplés électriquement par un résonateur en couche mince et à ondes acoustiques de volume shunté (38a ; c) ;
■ une cavité arrière sur ledit substrat (16), dans laquelle au moins deux résonateurs (38a à g) sont formés en dessus de la même cavité arrière (40),
**caractérisé par** :
■ une bande de renfort (18) qui s'étend sur ladite cavité arrière (40) dans le but de renforcer la membrane de la cavité arrière (40).

11. Circuit selon la revendication 10 comprenant une cavité arrière unique (40) en dessous desdits résonateurs (38a à g).

12. Circuit selon la revendication 10 ou 11 comprenant une pluralité de bandes de renfort (18) qui s'étend sur ladite cavité (40).

13. Circuit selon l'une quelconque des revendications 10 à 12, dans lequel lesdites bandes de renfort (18) sont réalisées en un matériau de substrat implanté d'ions.

14. Circuit selon l'une quelconque des revendications 10 à 13 comprenant une paire de bandes de renfort parallèles (18).

15. Circuit selon l'une quelconque des revendications 10 à 14, dans lequel chacun desdits résonateurs (38a à g) comprend une électrode supérieure (36), les électrodes supérieures (36a à f) desdits résonateurs (38a à g) étant coplanaires.
